# EUROPEAN PATENT APPLICATION

(11) **EP 4 215 649 A1**
(43) Date of publication of application: **26.07.2023**
(21) Application number: 22153061.1
(22) Date of filing: 24.01.2022
(51) Int. Cl.: C30B 23/06, C30B 29/02

(54) **PREPARATION OF SHAPED CRYSTALLINE LAYERS BY USE OF THE INNER SHAPE/SURFACE OF THE AMPULE AS A SHAPE FORMING SURFACE**

(71) Applicant: Timokhin, Ivan, Manchester M14 6JU (GB)
(72) Inventor: Timokhin, Ivan, Manchester M14 6JU (GB)
(74) Representative: Sach, Greg Robert

(57) **Abstract**

There is provided a device for forming specifically shaped crystalline layers comprising: a temperature gradient source providing a temperature gradient of at least 5°C between a first higher temperature point and a second lower temperature point; a specifically shaped ampoule with a first side located at the first point and a second side located at the second point, where the interior surface of the first side has the desired shape of the crystalline layers to be formed; a primary substance for forming the crystalline layers held within the ampoule.

## Description

The present invention relates generally to vapour transport crystal growth. Particularly, the present invention relates to a vapour transport crystal growth process for preparation of shaped crystalline layers of precious metals for use in jewellery/watchmaking/design applications.

### Background of the invention and prior art

The technique of chemical vapour transport inside closed ampoules is known and used for the purifying of small quantities of compounds or preparation of the individual crystals for various scientific experiments.

CN107400919A discloses a method of growing Ga2O3 single crystals by way of closed tube chemical vapour transport. This comprises the steps of putting Ga2O3 powder into a quartz tube and controlling the temperature distribution in a source region and a growth region.

US4299649 discloses a process for rapidly growing a selected II-VI compound semiconductor material of high purity. The detailed description of an apparatus is provided.

US5944891 provides a method for the heat treatment of a ZnSe crystal whereby the crystal can be prevented from crystallinity deterioration and caused to have low resistivity without occurrence of precipitates in the crystal.

RU2740590C1 describes an invention relating to production of CoSi monocrystals by chemical vapour transport. The process is carried out in quartz ampoules with a temperature difference in hot and cold zones of 100°C. The starting material is pre-synthesised CoSi, and the transporting agent is iodine. The temperature in the hot zone is 950-980°C. The invention ensures reduction of the working temperatures and the duration of the process, to five days, without reducing the size of the obtained crystals.

The chemical vapour deposition process is widely used to obtain a shaped coating or layers of various compounds in research and production applications.

US5691236A discloses an apparatus and method for performing a chemical vapour deposition CVD procedure to deposit an insulating layer over a surface of silicon wafer.

US5900279A offers processes for (CVD) comprising the steps of adding a metallic organic compound to a liquid to prepare a solution; vaporising the solution; decomposing the metallic organic solution; depositing a metallic film of a substrate.

US5472508 discloses an apparatus and method for chemical vapour deposition in which the reactants directed towards a substrate to be provided with one or more films are first subjected to an electric field.

EP1651793B1 discloses a simple CVD system and, in particular, a simple chemical vapour deposition system equipped to form a protective layer on jet engine components.

US2014331931 discloses an inline chemical vapour deposition method and system for fabricating a device. A detailed description of the system and a detailed drawing of the system are provided. The method is suitable for the manufacture of different types of devices including various types of solar cells such as copper indium gallium diselenide solar cells. The invention enables a high throughput of a CVD process's web substrate or a high-volume output of CVD processed discreate substrates.

US2010012030A1 describes a chemical vapour deposition process utilising chemical precursors that allow for the deposition of thin films to be conducted at or near the mass transport limited regime. The process has high deposition rates yet produces more uniform films, both compositionally and in thickness, than films prepared using conventional chemical precursors. In preferred embodiments, a higher order silane is employed to deposit thin films containing silicon that are useful in the semiconductor industry in various applications such as transistor gate electrodes.

JP2016035087A provides a chemical vapour deposition method by which a high growth rate can be materialised by preventing a deterioration in a raw material transport efficiency associated with a temperature gradient in a furnace. A chemical vapour deposition method according to the invention uses a chemical vapour deposition apparatus which has a first wall, a second wall facing the first wall, allows a substrate to be placed on the first wall, and has at least two gas supply ports. The first carrier gas is supplied from a gas supply port closer to the substrate than a port of the second carrier gas.

US20100310766A1 describes a roll-to-roll CVD system including at least two rollers that transport a web through a deposition chamber during CVD processing. A detailed description of the apparatus is provided. The deposition chamber defines a passage for the web to pass through while being transported by at least two rollers. The deposition chamber includes a plurality of process chambers that are isolated by barriers which maintain separate process chemistry in each of the plurality of process chambers. Each of the plurality of process chambers includes a gas input port and a gas exhaust port, and a plurality of CVD gas sources. At least two of the plurality of CVD gas sources is coupled to the gas input port of each of the plurality of process chambers.

US20020192376A1 discloses an invention related to the manufacture of semiconductor circuits on semiconductor wafers. The invention describes a method of chemical vapour deposition of materials on the wafer comprising the steps of solubilising a non-volatile precursor in an organic solvent; transporting said solution as a continuous liquid stream to a control chamber; evaporating said liquid solution in said control chamber to change the state of a non-volatile precursor to a vapour; creating a reaction between vapours of said non-volatile precursor; depositing the film on the surface of the wafer in response to said reaction.

Coating of details by various precious metals is commonly used, in particular, in jewellery, and allows the improving of aesthetic and functional properties of items.

US6037001A discloses a method for depositing copper-based films on a substrate. The method includes introducing into a deposition chamber: (i) a substrate; (ii) a copper source precursor in a vapour state; (iii)and at least one copper(II) beta-diketonate precursor; and (iv) at least one transport gas, different than said copper source precursor. The reaction substrate temperature is maintained at from about 50°C to about 500°C for a period of time sufficient to deposit a copper-based film on said substrate.

US5491005 discloses a method of growing a gold film having high electromigration resistance and a flat surface, and that is capable of being buried in contact holes.

US2002065427A1 describes organometallic compounds for manufacturing a ruthenium film or a ruthenium compound film by a chemical vapour deposition process, for manufacturing an iridium film or an iridium compound film by a chemical vapour deposition process and a process for preparing said organometallic compounds.

It is an object of the present invention to provide a reliable, production-worthy method for the fast preparing of a shaped crystalline layer. Said shaped crystalline layer according to the present invention is defined as a layer, containing crystals or crystal bundles, characterised by containing visually detectable small, shaped crystals with crystalline facets. Said shaped crystalline layer has attractive appearance, high lustre and can be used in various jewellery/watchmaking/design applications alone or after incorporation into other items. Said shaped crystalline layer has a shape that is the most suitable for the application, and preferably has a shape most suitable for the incorporation into items; said shape can be a surface that is, for example, flat, bent, bowed, arcuate, wavy, corrugated or crimped. Said surface is characterised by having uniform average thickness across the surface and is characterised by having uniformly distributed reflecting crystalline facets; such facets are visible with the naked eye.

To our best knowledge, the prior art techniques do not include a method to obtain a shaped crystalline layer with a desired shape, and a number of crystalline facets and thickness. It was found that the steps of placing a substance in a specially shaped ampoule, optionally filling the ampoule with a transport agent or a transport agent precursor, placing said ampoule in the temperature gradient and, optionally, moving said ampoule horizontally to reduce non-uniformity of horizontal temperature gradient provide a shaped crystalline layer with the desired characteristics suitable for various jewellery/watchmaking/design applications alone or after incorporation into other items.

It is the object of the present invention to provide a process to obtain a shaped crystalline layer comprising the steps: providing the substance, placing the substance in an ampoule with a specially shaped inner surface, optionally, adding a transport agent or a transport agent precursor into the ampoule with the substance; said precursor is able to reversibly react with the substance at elevated temperature or is able to release at least one substance at elevated temperature that reversibly reacts with the substance at elevated temperature; placing the ampoule into temperature gradient for shaped crystalline layer growth; optionally, moving said ampoule horizontally to reduce non-uniformity of horizontal temperature gradient.

### Statement of invention

According to a first embodiment of the invention, there is provided a device for forming specifically shaped crystalline layers comprising: a temperature gradient source providing a temperature gradient of at least 5°C between a first higher temperature point and a second lower temperature point; a specifically shaped ampoule with a first side located at the first point and a second side located at the second point, wherein the interior surface of the first side has the desired shape of the crystalline layers to be formed; and a primary substance for forming the crystalline layers held within the ampoule.

An embodiment of the first aspect further comprising: an actuation mechanism for the ampoule to be placed on, the actuation mechanism providing motion to the ampoule. Preferably the actuation mechanism is a rotation mechanism having a rotation axis substantially parallel to the direction of the temperature gradient. Alternatively, other types of movement can be made to move the ampoule in the direction perpendicular to the temperature gradient (to equalize temperature non uniformity within the first side of the ampoule).

An embodiment of the first aspect further comprising a transport agent or its precursor within the ampoule; said precursor being able to reversibly react with, or release at least one secondary substance that can reversibly react with, the primary substance at an elevated temperature.

An embodiment of the first aspect wherein the primary substance is at least one of: a precious metal, its compounds or its alloys. The metal may be at least one of: ruthenium, rhodium, osmium, ruthenium, platinum, gold, iridium or rhenium.

An embodiment of the first aspect wherein at least the first side of the ampoule is made from or coated in an inert material having a high melting point. The inert material may be quartz glass.

An embodiment of the first aspect wherein the transport agent precursor is in the form of an inorganic salt with the general formula MeLx, where Me is a metal and Lx a ligand. The ligand may be a halogen.

An alternative embodiment of the first aspect wherein the transport agent or precursor is a mixture of three substances: a transported metal; another metal; and one or more halogen.

The metal of the transport agent or precursor may be selected from but not limited to Al, Ti, Cr, Mn, Fe, Co, Ni, Cu, Zn, Ru, Rh, Pd, Sn, Mo, W, Re, Os, Ir, Pt, Pb Ga, In, and Tl.

An embodiment of the first aspect wherein the first point is above 100°C and the temperature gradient between the first and second point is over 5°C.

An embodiment of the first aspect wherein the rotating mechanism has a rotation speed of between one rotation a week and 600 rotations a minute. The rotation speed of the rotating mechanism is preferably between one rotation an hour and one rotation a minute.

According to a second aspect of the invention there is provided a method for forming specifically shaped crystalline layers using the device defined in the first aspect, comprising the steps of:
a. Placing the primary substance in the specifically shaped ampoule;
b. Adding the transport agent or transport agent precursor into the specifically shaped ampoule;
c. Placing the ampoule into the temperature gradient for shaped crystalline layer growth.
   An embodiment of the second aspect comprises the additional step of:
d. actuating the ampoule to negate any temperature fluctuations across the interior surface of the first side of the ampoule. Preferably, this step comprises rotating the ampoule around a rotation axis which is parallel to the direction of the temperature gradient.

An embodiment of the second aspect wherein the ampoule is in the temperature gradient for between one hour and one month, while the crystalline layers are formed. The ampoule may be within the temperature gradient for between one day and one week while the crystalline layers are formed.

### Brief description of the drawing

The invention will be described in more detail, by way of example, with reference to the following drawing:

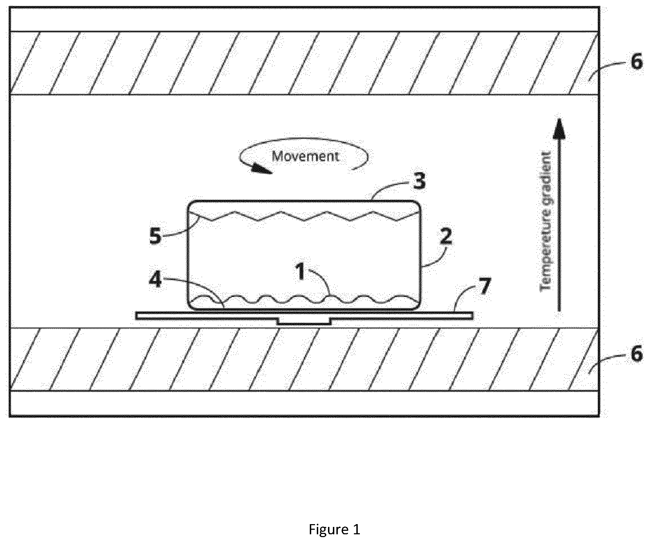

Figure 1 schematically depicts the process of obtaining a shaped crystalline layer in accordance with the principles of the present invention.

### Detailed description

Next, referring to the preferred embodiments, the detailed description of the invention is provided.

In a first embodiment of the present invention to obtain a shaped crystalline layer, a substance 1 is placed in a specially shaped ampoule 2; said ampoule has a top surface 3 and a bottom surface 4. The inner side of top surface 3 of the ampoule has the form and the shape of the desired crystalline layer 5. We have observed, surprisingly, that the top surface serves as a support and transmits its form and shape to a shaped crystalline layer. Varying the form and shape of said top surface of the ampoule is very easy, to adjust the form and shape of shaped crystalline layer and obtain said shaped crystalline layers quickly and cheaply, and with the shape most suitable for customisable jewellery/watchmaking/design applications alone or after incorporation into other items. In order to accelerate the growth of the shaped crystalline layer, a transport agent or precursor is added to said ampoule. Said transport agent or precursor is characterised by an ability to reversibly react with substance 1 at elevated temperature or is capable of releasing at least one substance at elevated temperature that reversibly reacts with substance 1 at elevated temperature. The specially shaped ampoule 2 is placed into a temperature gradient which is provided by heating elements 6 (lower "heating" element 6 can optionally just be insulation); said heating elements are part of an oven or a furnace that is capable of providing an elevated temperature, in particular, a temperature higher than 100°C. In order to improve the quality and, in particular, make the thickness of the shaped crystalline layer more homogeneous along a horizontal dimension, the specially shaped ampoule 2 containing the substance 1, optionally containing the transport agent or precursor, which is placed in the temperature gradient, is optionally moved to reduce non-uniformity of the horizontal temperature gradient. For this purpose, the specially shaped ampoule 2 is placed on the moving platform 7, which is mounted between heating elements 6. Said platform is mechanically moved in the horizontal directions between said elements.

In a second embodiment of the present invention said substance 1 is a metal or a metal compound, in particular, chosen from but not limited to a group of precious metals or their compounds, preferably chosen from a group ruthenium, rhodium, osmium, ruthenium, platinum, gold, iridium, rhenium or their compounds. In one particular embodiment of the present invention, said metal compound has a general chemical formula of MyLx, where M is a metal and L is a ligand which is capable of coordinating to the metal; such compound is characterised by an ability to decompose at an elevated temperature, in particular, at a temperature higher than 100°C, releasing a metal, from which a shaped crystalline layer is made. In particular, L might be an organic or inorganic ligand, preferably an inorganic ligand; more preferably, L is a halogenic ligand, most preferably Cl- or Br-.

In a third embodiment of the present invention, said specially shaped ampoule 2 has a top surface 3; said top inner surface has the form and shape of the desired shaped crystalline layer 5 and the ampoule 2 is made of or coated with an inert material. Said material is characterised by an ability not to react with the substance 1 and/or with the transport agent or precursor at elevated temperature at which the shaped crystalline layer 5 is obtained during the whole growing process. In particular, said material is characterised by being inert, cheap and easy to shape to provide the ampoule with the top surface 3 having the shape of the desired crystalline layer 5. Preferably, said material has a high melting point, more preferably said material is glass or quartz, and most preferably quartz glass. In one particular embodiment of the present invention, the inner surface of the specially shaped ampoule 2 is coated with an inorganic thin layer (for example TiO2 or Al2O3. Any known method can be used to provide such a coating layer. We have surprisingly found that the presence of said inorganic layer on the inner surface of the specially shaped ampoule 2 facilitates the separation of the shaped crystalline layer 5 from the top surface 3 of the specially shaped ampoule 2, in particular, when the shape of the top surface 3 of the specially shaped ampoule 2 is not flat, but wavy, corrugated or crimped. In addition, we have observed, surprisingly, that the presence of the said thin coating layer of the inner surface of the specially shaped ampoule 2 improves the thermal stability of the specially shaped ampoule 2 and prevents the ampoule from cracking when the ampoule undergoes a quick cooling or is treated with a harsh temperature gradient.

In a further embodiment of the present invention, a transport agent or precursor is added to the specially shaped ampoule 2. The addition of the transport agent or precursor is optional, but we have observed, surprisingly, that adding said transport agent or precursor to the specially shaped ampoule 2 drastically accelerates the growth of the shaped crystalline layer 5. Said transport agent or precursor is a chemical substance or a mixture of chemical substances that is capable of reversibly reacting with substance 1 at elevated temperature or is capable of releasing at least one substance that reversibly reacts with substance 1 at elevated temperature. In one particular embodiment of the present invention, said transport agent or precursor is a gas, in particular, a halogen gas. In another particular embodiment of the present invention, said transport agent or precursor is any chemical substance that is capable of releasing a gas at an elevated temperature higher than 100°C; said released gas is capable of reversibly reacting with the substance 1 at elevated temperature higher than 100°C; preferably, said released gas is a halogen gas. In another particular embodiment of the present invention, said transport agent or precursor is inorganic salt with a general chemical formula MeyLx where Me is one or more metals, chosen from but not limited to a group of metals Al, Ti, Cr, Mn, Fe, Co, Ni, Cu, Zn, Ru, Rh, Pd, Sn, Mo, W, Re, Os, Ir, Pt and Pb, and L is a ligand capable of coordination to said metal; preferably L is an inorganic ligand, and most preferably L is a halogen. In further particular embodiment of the present invention, said transport agent or precursor is a mixture of two substances, one of which is a metal chosen from but not limited to a group of metals Al, Ti, Cr, Mn, Fe, Co, Ni, Cu, Zn, Ru, Rh, Pd, Sn, Mo, W, Re, Os, Ir, Pt and Pb and another is a gas, in particular, a gas which is capable of reacting with said metal at elevated temperature higher than 100°C; more particularly, the gas is a halogen gas.

In a further embodiment of the present invention, the temperature gradient is set, in order to provide chemical transport from the bottom surface 4 to the top surface 3 of said specially shaped ampoule 2; preferably, it is set in order that the bottom surface 4 has a temperature lower than the top surface 3 of said ampoule 2. According to our observation, such a temperature gradient where the temperature of the bottom surface 4 of the specially shaped ampoule 2 is lower than the temperature of the top surface 3 of said ampoule is crucial for obtaining the shaped crystalline layer 5 with the desired shape and quality. In one particular embodiment of the present invention, the temperature difference between bottom surface 4 and top surface 3 is no less than 50°C, and most preferably the temperature of the bottom surface 4 is set so that the temperature is higher than 100°C and the temperature difference between the bottom surface 4 and the top surface 3 is no less than 50°C. According to our observation, setting the temperature difference between the bottom surface 4 and the top surface 3 lower than 5°C negatively affects the growth rate of the shaped crystalline layer 5 (preferably the temperature difference is above 50°C). Said temperature gradient can be provided by any means known to the skilled artisan; preferably the said gradient is provided by placing said specially shaped ampoule 2 into a furnace. Any type of furnace that can provide the required temperature gradient can be used; in particular, a muffle furnace that provides the required temperature gradient can be used.

In a further embodiment of the present invention, said specially shaped ampoule 2 containing a substance 1 is placed in the temperature gradient for a period of time sufficient to provide a shaped crystalline layer 5 with the desired thickness and shape. According to our observation, changing the time period for which said specially shaped ampoule 2 is placed into said temperature gradient, the thickness of the shaped crystalline layer can easily be adjusted to the thickness most suitable for jewellery/watchmaking/design applications alone or after incorporation into other items. Preferably, the specially shaped ampoule 2 is placed into the temperature gradient for a time period to obtain the shaped crystalline layer with a thickness of between 0.1 mm and 5 mm, more preferably with a visible crystalline surface that reflects light. The said time period is chosen of between one hour and one month, more preferably between one hour and one week, and most preferably between one day and one week.

In a further embodiment of the present invention, said specially shaped ampoule 2 containing a substance 1 is placed in the temperature gradient for a period of time sufficient to provide a shaped crystalline layer5 with the desired thickness and shape, then is horizontally moved to reduce any non-uniformity of horizontal temperature gradient. The movement of the specially shaped ampoule 2 is optional. But, according to our observation, movement essentially improves the quality of the shaped crystalline layer 5; in particular, it reduces the thickness fluctuation along the shaped crystalline layer 5, which is crucial for some jewellery/watchmaking/design applications. Said movement according to the present invention can be carried out by any means known to the skilled artisan. In one particular embodiment of the present invention, such movement is realised by providing a moving platform 7 that is mounted between heating elements 6; in particular, when the platform is moved, preferably, the movement is to be a rotation. In one particular preferred embodiment of the present invention, the rotation is realised at a speed of one turn per day to 60 turns per minute; more preferably it rotates at a speed of between one turn per hour and one turn per minute.

In a further embodiment of the present invention, said shaped crystalline layer obtained according to the present invention is used in jewellery/watchmaking/design applications alone or after incorporation into other items. Said shaped crystalline layer due to its preciousness and lustre is highly suited to use in jewellery/watchmaking/design applications and definitely increases the value of the items into which the shaped crystalline layer obtained according to the present invention is incorporated. We have observed, surprisingly, that the crystalline pattern of each shaped crystalline layer obtained according to the present invention is unique; in particular, the combination of shapes and forms of monocrystals which are part of the shaped crystalline layer is unique for each shaped crystalline layer obtained according to the present invention. In one particular embodiment of the present invention, the property of the uniqueness of the shaped crystalline layer can be optionally used to identify the uniqueness or exclusivity of the items into which the shaped crystalline layer is incorporated. The identification of the uniqueness can be realised by any means known to the skilled artisan. In particular, the uniqueness of the shaped crystalline layer and/or the items in which the shaped crystalline layer is incorporated can be realised by picturing or scanning the shaped crystalline layer as the item is produced and saving the picture or scan into the electronic database. The crystalline layer can have a physically unclonable function or "PUF" incorporated within its design further adding to its security. Due to the fact that it is not possible to obtain another shaped crystalline layer with exactly the same crystalline pattern, a comparison of the picture or scan of the shaped crystalline layer of the item whose uniqueness or exclusivity is in question with the database picture or scan can serve as proof of uniqueness and/or exclusivity of the item.

In a preferred embodiment of the invention, 25 g of osmium powder is placed into a specially shaped ampoule made of quartz glass. In this particular example, the specially shaped ampoule is cylindrical with a cell diameter of 60 mm, and a cell height of 40 mm. The shape of the top surface is flat, and the form of the top surface is round. The ampoule is filled with chlorine gas, which serves as a transport agent or precursor (pressure 300 mbar) and sealed with an oxypropane torch. The ampoule is placed into heating apparatus onto a moving platform that is constantly being rotated. The rotation speed is six turns per hour. The temperature of the heater above the ampoule is set to 800°C. This has provided a temperature gradient of 150°C. The ampoule is placed in the furnace for 72 hours. After this period of time, the furnace is switched off and allowed to cool down. A shaped crystalline layer whose shape is flat and whose form is round, made of osmium, is removed by breaking the ampoule.

The invention has been described with reference to a preferred embodiment. The description is intended to enable a skilled person to make the invention, not to limit the scope of the invention. The scope of the invention is determined by the claims.

## Claims

1. A device for forming specifically shaped crystalline layers comprising: a temperature gradient source providing a temperature gradient of at least 5°C between a first higher temperature point and a second lower temperature point; a specifically shaped ampoule with a first side located at the first point and a second side located at the second point, wherein the interior surface of the first side has the desired shape of the crystalline layers to be formed; and a primary substance for forming the crystalline layers held within the ampoule.

2. A device according to claim 1, further comprising an actuation mechanism for the ampoule to be placed on in use, the actuation mechanism providing motion to the ampoule.

3. A device according to claim 2, wherein the actuation mechanism is a rotation mechanism having a rotation axis substantially parallel to the direction of the temperature gradient.

4. A device according to any preceding claim, further comprising a transport agent or its precursor within the ampoule, said precursor being able to reversibly react with, or release at least one secondary substance that can reversibly react with, the primary substance at an elevated temperature.

5. A device according to any preceding claim, wherein the primary substance is at least one of: a precious metal, its compounds or its alloys.

6. A device according to claim 5, wherein the primary substance comprises at least one of: ruthenium, rhodium, osmium, ruthenium, platinum, gold, iridium or rhenium.

7. A device according to any preceding claim wherein at least the first side of the ampoule is made from or coated with an inert material having a melting point higher than the highest operating temperature of the device.

8. A device according to claim 4 or any other preceding claim dependent on claim 4, wherein the transport agent or precursor is in the form of an inorganic salt with the general formula MeLx, where Me is a metal and Lx is a ligand.

9. A device according to claim 4, or any one of claims 5 to 7 when dependent on claim 4, wherein the transport agent or precursor is a mixture of three substances: a transported metal; another metal; and one or more halogen.

10. A device according to claim 4 or any other preceding claim dependent on claim 4, wherein the metal of the transport agent or precursor may be selected from but not limited to Al, Ti, Cr, Mn, Fe, Co, Ni, Cu, Zn, Ru, Rh, Pd, Sn, Mo, W, Re, Os, Ir, Pt, Pb Ga, In, and Tl.

11. A device according to any preceding claim wherein the first point is above 100°C and the temperature gradient between the first and second point is over 5°C.

12. A device according to claim 3 or any other preceding claim dependent on claim 3, wherein the rotating mechanism has a rotation speed of between one rotation a week and 600 rotations a minute.

13. A method for forming specifically shaped crystalline layers using the device defined in the first aspect, comprising the steps of:
a. Placing the primary substance in the specifically shaped ampoule;
b. Adding the transport agent or transport agent precursor into the specifically shaped ampoule;
c. Placing the ampoule into the temperature gradient for shaped crystalline layer growth.

14. A method according to claim 13, comprising the additional step of:
d. actuating the ampoule to negate any temperature fluctuations across the interior surface of the first side of the ampoule.

15. A method according to claim 13 or claim 14, wherein the ampoule is in the temperature gradient for between one hour and one month, while the crystalline layers are formed.

## Amended claims

### Amended claims in accordance with Rule 137(2) EPC.

1. A method of forming a crystalline layer of a desired form, shape, and average thickness, comprising the steps of
a. Selecting a desired form, shape, and average thickness for a crystalline layer to be formed;
b. Forming an ampoule having a first internal surface of said desired form and shape;
c. Providing a primary substance within the ampoule;
d. Sealing the ampoule;
e. Generating a heat gradient along the ampoule of at least 5 degrees Celsius, with the highest temperature at the first internal surface;
f. Maintaining the heat gradient until a crystalline layer of the desired average thickness forms on the first internal surface.

2. A method of forming a crystalline layer of a desired form, shape, and average thickness, according to claim 1, wherein the step of generating a heat gradient comprises generating a temperature of at least 100 degrees Celsius at the first internal surface.

3. A method of forming a crystalline layer of a desired form, shape, and average thickness, according to claim 1 or claim 2, wherein the step of maintaining the heat gradient until a crystalline layer forms on the first internal surface comprises maintaining the heat gradient for between one hour and one month.

4. A method of forming a crystalline layer of a desired form, shape, and average thickness, according to any preceding claim, wherein the step of forming an ampoule further comprises the step of coating the inner surface of the ampoule with a layer of inert material.

5. A method of forming a crystalline layer of a desired form, shape, and average thickness, according to claim 4, wherein the inorganic thin layer comprises one of TiO2 or Al2O3.

6. A method of forming a crystalline layer of a desired form, shape, and average thickness, according to any preceding claim, wherein the step of maintaining the heat gradient until a crystalline layer forms of the desired average thickness further comprises providing motion to the ampoule while the heat gradient is generated.

7. A method of forming a crystalline layer of a desired form, shape, and average thickness, according to claim 6, wherein the step of providing motion to the ampoule comprises rotating the ampoule about an axis of rotation substantially parallel to the direction of the temperature gradient.

8. A method of forming a crystalline layer of a desired form, shape, and average thickness, according to claim 7, wherein the step of rotating the ampoule comprises rotating the ampoule with a rotational velocity of between one revolution per week and six hundred revolutions per minute.

9. A method of forming a crystalline layer of a desired form, shape, and average thickness, according to any preceding claim, wherein the primary substance comprises one of a precious metal; a compound of a precious metal; an alloy of a precious metal.

10. A method of forming a crystalline layer of a desired form, shape, and average thickness, according to any preceding claim, wherein the substance comprises one of ruthenium, rhodium, osmium, platinum, gold, iridium, or rhenium.

11. A method of forming a crystalline layer of a desired form, shape, and average thickness, according to any preceding claim, comprising the further step, between step b) and step d), of providing within the ampoule a transport agent or its precursor, the transport agent being selected so as to reversible react with the primary substance at an elevated temperature.

12. A method of forming a crystalline layer of a desired form, shape, and average thickness, according to claim 11, wherein the transport agent is an inorganic salt with the general formula Me1Me2L1L2, where Me1 and Me2 are metals and L1 and L2 are ligands.

13. A method of forming a crystalline layer of a desired form, shape, and average thickness, according to claim 11, wherein the transport agent comprises a mixture of three substances: a transported metal; another metal; and a halogen.

14. A method of forming a crystalline layer of a desired form, shape, and average thickness, according to any one of claims 11 to 13, wherein the metal of the transport agent is one of Al, Ti, Cr, Mn, Fe, Co, Ni, Cu, Zn, Ru, Rh, Pd, Sn, Mo, W, Re, Os, Ir, Pt, Pb, Ga, In, and Tl.
